# EUROPEAN PATENT APPLICATION

(11) **EP 3 572 586 A1**
(43) Date of publication of application: **27.11.2019**
(21) Application number: 18196282.0
(22) Date of filing: 24.09.2018
(51) Int. Cl.: E01F 7/06

(54) **DEVICE FOR SUPPORTING AN ANTI-GLARE PLATE AND ANTI-GLARE DEVICE**

(30) Priority: 25.05.2018 CN 201810512090
(71) Applicant: Beijing Apollo Ding Rong Solar Technology Co., Ltd., Beijing 100176 (CN)
(72) Inventor: SHA, Zhenhua, Beijing, Beijing 100176 (CN)
(74) Representative: Roman, Alexis

(57) **Abstract**

A device for supporting an anti-glare plate and an anti-glare device are provided. The device for supporting an anti-glare plate includes a supporting member and a connecting member, the connecting member is connected with the supporting member and the anti-glare plate, and the anti-glare plate is capable of rotating relative to the supporting member. The present disclosure is used for fixing the anti-glare plate.

## Description

### Related Applications

This application is based upon and claims priority to Chinese Patent Application No. 201810512090.0 filed on May 25, 2018, the contents of which are incorporated herein by reference in its entirety.

### Technical Field

The present disclosure relates to the technical field of anti-glare, and in particular to a device for supporting an anti-glare plate and an anti-glare device.

### Background

An anti-glare plate is to overcome the glare of opposite vehicle lamps and is mainly a traffic safety product mounted on a central separation zone of an expressway.

The anti-glare plates are arranged at intervals on the central separation zone of the expressway, that is, one anti-glare plate is arranged every a preset distance. In this way, when two vehicles meet, high beams of the vehicles will be irradiated to multiple anti-glare plates on the separation zone, so that the irradiation of the high beams is prevented from affecting the driving of drivers of opposite vehicles, and the safety of vehicle driving is improved. However, due to a very fast vehicle speed on the expressway, when a vehicle passes through the anti-glare plate at a high speed, relatively large barometric fluctuation will be generated around the vehicle and the barometric fluctuation will drive the anti-glare plate on the separation zone to vibrate violently, so that the service life of the anti-glare plate is seriously affected.

### Summary

In one aspect, the embodiments of the disclosure provide a device for supporting an anti-glare plate, which includes a supporting member and a connecting member, wherein the connecting member is connected with the supporting member and the anti-glare plate, and is configured to enable the anti-glare plate to rotate relative to the supporting member. Optionally, the supporting member has a first connecting hole and a second connecting hole;
the connecting member comprises a rotating shaft, one end of the rotating shaft is rotatably connected to the first connecting hole, the other end of the rotating shaft is rotatably connected to the second connecting hole, and the anti-glare plate is fixed to the rotating shaft.

Optionally, the connecting member further comprises a fixed part, the fixed part is configured to fix the anti-glare plate to the rotating shaft, the fixed part is fixed to the rotating shaft, the fixed part has a frame, the frame is configured to accommodate the anti-glare plate.

Optionally, the device further comprises a buffer assembly, the buffer assembly is configured to apply resistance to the rotating shaft when the rotating shaft is rotated.

Optionally, the buffer assembly comprises a first connecting unit, a second connecting unit and an elastic component, the first connecting unit is fixed on the rotating shaft, the second connecting unit is fixed on the supporting member, and the first connecting unit is connected to the second connecting unit through the elastic component.

Optionally, the supporting member comprises a first supporting beam, a second supporting beam and a supporting frame, the supporting frame is configured to support the first supporting beam and the second supporting beam, the first connecting hole is formed on the first supporting beam, and the second connecting hole is formed on the second supporting beam.

Optionally, the supporting member further comprises a connecting seat, the connecting seat is arranged on the first supporting beam, the connecting seat comprises a first seat body and a second seat body, the first seat body and the second seat body are detachably connected, the first seat body has a first groove, the second seat body has a second groove, the first groove and the second groove are configured to cooperatively form the first connecting hole.

Optionally, the supporting member further comprises a connecting seat, the connecting seat is arranged on the second supporting beam, the connecting seat comprises a first seat body and a second seat body, the first seat body and the second seat body are detachably connected, the first seat body has a first groove, the second seat body has a second groove, the first groove and the second groove are configured to cooperatively form the second connecting hole.

Optionally, the supporting member further comprises two connecting seats, one of the two connecting seats is arranged on the first supporting beam, and the other one of the two connecting seats is arranged on the second supporting beam, each one of the two connecting seats comprises a first seat body and a second seat body, the first seat body and the second seat body are detachably connected, the first seat body has a first groove, the second seat body has a second groove, the first groove and the second groove are configured to cooperatively form the first connecting hole or the second connecting hole. Optionally, the supporting member further comprises a plurality of connecting structures, the connecting structures are arranged on the first supporting beam and the second supporting beam, the connecting structures are adapted to allow the connecting seats be detachably fixed on the first supporting beam and the second supporting beam.

In another aspect, the embodiments of the disclosure further provide an anti-glare device, the anti-glare device includes an anti-glare plate and a device for supporting the anti-glare plate, wherein the anti-glare plate is mounted on the device, the device includes a supporting member and a connecting member, the connecting number is connected with the supporting member and the anti-glare plate, and is configured to enable the anti-glare plate to rotate relative to the supporting member.

Optionally, the first supporting beam and the second supporting beam are arranged in an extension manner along a length direction of an expressway; and the anti-glare plate is suspended at lower sides of the first supporting beam and the second supporting beam. Optionally, the anti-glare plate comprises a first glass layer, a photoelectric conversion chip and a second glass layer, the first glass layer, the photoelectric conversion chip and the second glass layer are arranged in a laminated manner.

Optionally, both of the first glass layer and the second glass layer are made of ground glass.

Optionally, the photoelectric conversion chip is a thin-film solar cell chip.

This embodiment of the disclosure provides the device for supporting an anti-glare plate, which is used for improving the service life of the anti-glare plate. However, in the prior art, the anti-glare plate is typically arranged on the separation zone of the expressway in a fixed manner. Due to a very fast vehicle speed on the expressway, when a vehicle passes through the anti-glare plate at a high speed, relatively large barometric fluctuation will be generated around the vehicle and the barometric fluctuation will drive the anti-glare plate on the separation zone to vibrate violently, so that the service life of the anti-glare plate is seriously affected. Compared with the prior art, the device for supporting an anti-glare plate provided by this embodiment of the disclosure includes the supporting member and the connecting member, and the connecting member is adapted to be connected with the supporting member and the anti-glare plate, and is configured to enable that the anti-glare plate can be rotated relative to the supporting member. When the vehicle is driven to pass through the anti-glare plate, the barometric fluctuation generated by the vehicle may be acted on the anti-glare plate. Since the anti-glare plate is fixed on the connecting member, the anti-glare plate may be rotated around the supporting frames. After the barometric fluctuation disappears, the anti-glare plate may be rotated again back to a preset position under the action of gravity; and in this way, the acting force generated by the barometric fluctuation may be removed and the service life of the anti-glare plate is improved.

### Brief Description of the Drawings

FIG. 1 is a structural schematic diagram of a device for supporting an anti-glare plate provided by an embodiment of the disclosure.
FIG. 2 is a schematic diagram of a part of a device for supporting an anti-glare plate provided by an embodiment of the disclosure.
FIG. 3 is a schematic diagram of a part of a fixing frame provided by an embodiment of the disclosure.
FIG. 4 is an exploded view of a device for supporting an anti-glare plate provided by an embodiment of the disclosure.
FIG. 5 is a schematic diagram of a part of a device for supporting an anti-glare plate provided by an embodiment of the disclosure.

### Detailed Description

In order to further describe the technical means adopted by the disclosure to achieve the predetermined purpose and effects of the technical means, the specific embodiments, structures, features and effects of the device for supporting an anti-glare plate proposed according to the disclosure are described as follows in detail.

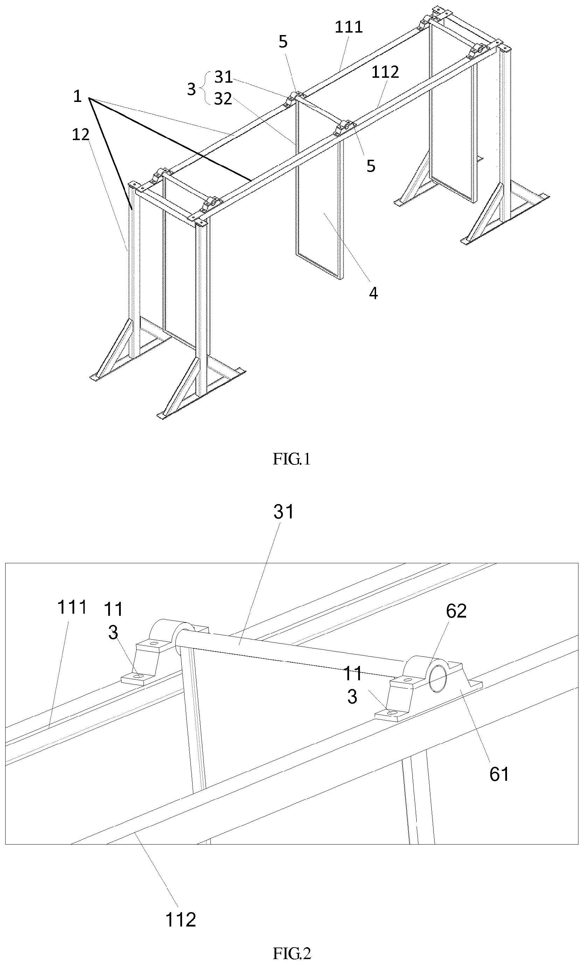

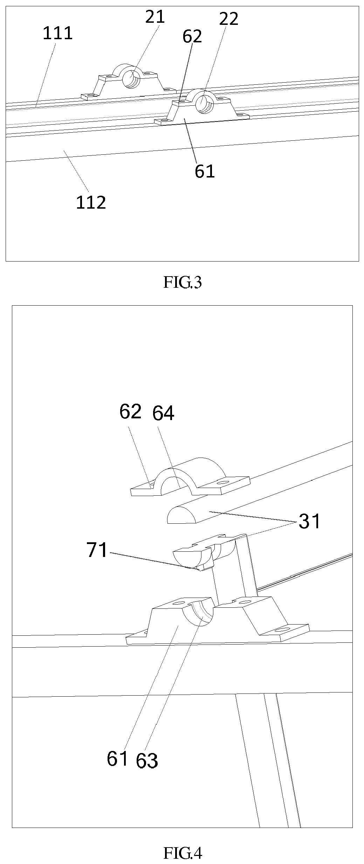

As shown in FIG. 1 to FIG. 3, an embodiment of the disclosure provides a device for supporting an anti-glare plate 4, which includes a supporting member 1 and a connecting member 3, the connecting member 3 is connected with the supporting member 1 and the anti-glare plate 4, the anti-glare plate 4 is rotatably mounted to the supporting member 1 through the connecting member 3.

Wherein, the supporting member 1 may be of a frame type structure. In order to guarantee the use intensity of the supporting member, the supporting member 1 may be made of a metal material and its specific structural style may be designed according to a site actual condition and will not be specifically defined here. Wherein, the supporting member 1 is mainly arranged on a separation zone of an expressway and is arranged along the expressway. The bottom of the supporting member 1 may be fixed on the ground of the separation zone of the expressway, and its fixing manner may employ bolted connection, welding and the like and will not be specifically defined here. As the expressway is relatively long, multiple devices for supporting the anti-glare plate 4 connected one another may be sequentially arranged along a length direction of the expressway; and each of the devices for supporting the anti-glare plate 4 is provided with at least one anti-glare plate 4, so as to implement the anti-glare effect of the expressway. The number of the devices for supporting the anti-glare plate 4 may be arranged according to a length of the supporting member 1 and a length of the expressway and will not be specifically defined here. In addition, the supporting member 1 and the connecting member 3 are rotatably connected. The connecting member 3 is mainly used for fixing the anti-glare plate 4, and its structural manner may be various and will not be defined one by one here. When the anti-glare plate 4 is fixed on the connecting member 3, the anti-glare plate 4 may be in a suspending state; and when an acting force is applied to the anti-glare plate 4, the anti-glare plate 4 may be rotated around the supporting member 1.

This embodiment of the disclosure provides the device for supporting the anti-glare plate4, which is used for improving the service life of the anti-glare plate. However, in the prior art, the anti-glare plate is typically arranged on the separation zone of the expressway in a fixed manner. Due to a very fast vehicle speed on the expressway, when a vehicle passes through the anti-glare plate at a high speed, relatively large barometric fluctuation will be generated around the vehicle and the barometric fluctuation will drive the anti-glare plate on the separation zone to vibrate violently, so that the service life of the anti-glare plate is seriously affected. Compared with the prior art, the device for supporting an anti-glare plate provided by this embodiment of the disclosure includes the supporting member and the connecting member, and the connecting member is adapted to be connected with the supporting member and the anti-glare plate, and is configured to enable that the anti-glare plate can be rotated relative to the supporting member. When the vehicle is driven to pass through the anti-glare plate, the barometric fluctuation generated by the vehicle may be acted on the anti-glare plate. Since the anti-glare plate is fixed on the connecting member, the anti-glare plate may be rotated around the supporting frames. After the barometric fluctuation disappears, the anti-glare plate may be rotated again back to a preset position under the action of gravity; and in this way, the acting force generated by the barometric fluctuation may be removed and the service life of the anti-glare plate is improved.

There may be various structural styles of the connecting member 3. Optionally, the supporting member 1 is provided with a first connecting hole 21 and a second connecting hole 22. The connecting member 3 includes a rotating shaft 31. The two ends of the rotating shaft 31 are respectively and rotatably connected to the first connecting hole 21 and the second connecting hole 22, wherein the anti-glare plate 4 is fixed to the rotating shaft 31. In this embodiment, the first connecting hole 21 and the second connecting hole 22 may be arranged oppositely. The two ends of the rotating shaft 31 are respectively and rotatably connected to the first connecting hole 21 and the second connecting hole 22. Optionally, the connecting member 3 may further include a fixing part 32 configured to fix the anti-glare plate 4 to the rotating shaft 31, and the anti-glare plate 4 may be fixed on the fixing part 32. In this way, the anti-glare plate 4 may rotate around the supporting member 1 through the fixing part 32 and the rotating shaft 31. Moreover, the connecting member 3 proposed by the disclosure has simple structure and low manufacturing cost, and may enable the anti-glare plate 4 to rotate along a preset track and prevent it from hitting against the supporting member 1 during rotation. Therefore, the service life of the anti-glare plate is improved. In addition, besides the rotating shaft may be fixedly connected with the anti-glare plate and is rotatably connected with the supporting member, there may further have other implementation manners. Optionally, the rotating shaft and the supporting member are in fixed connection, and the rotating shaft and the anti-glare plate are in relative rotational connection.

Besides the connecting member 3 may be connected to the supporting member 1 through the rotating shaft 31, it may further be connected to the supporting member 1 by a hinged manner. Through the hinged manner, the rotation between the connecting member 3 and the supporting member 1 may be more firm.

There may be various structural styles of the fixing part 32. Optionally, the fixing part 32 is provided with a frame configured to accommodate the anti-glare plate 4. In this embodiment, the connection manner between the fixing part 32 and the rotating shaft 31 may be integral molding and may also be welding, and will not be specifically defined here. The frame configured to accommodate the anti-glare plate 4 is further arranged on the fixing part 32, the frame is of a frame structure formed by enclosing multiple frame arms into one circle, and the anti-glare plate 4 may be fixed in the frame. Specifically, the multiple frame arms may surround edges of the anti-glare plate 4 with one circle and each of the edges of the anti-glare plate 4 may be mutually fixed with a corresponding frame arm. Moreover, the frame type fixing part 32 has simple and convenient structure and relatively low manufacturing cost, and can further guarantee the connection strength. Wherein, the frame arms may be made of a metal material, such as a steel material and an aluminum alloy material. Likewise, the frame arms may also be made of other materials, such as an ethylene-tetrafluoroethylene copolymer, a polyvinyl fluoride and a thermoplastic elastomer, and will not be defined here.

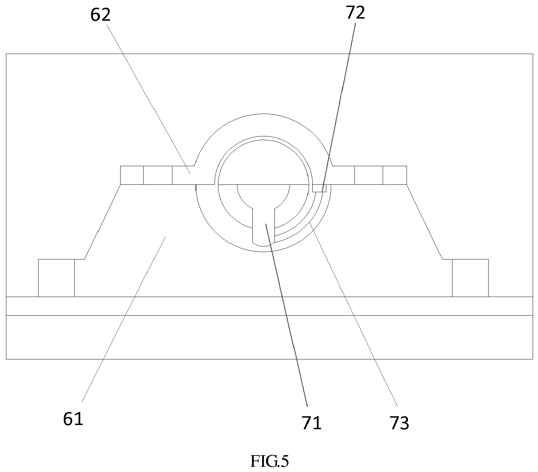

As shown in FIG. 1, FIG. 4 and FIG. 5, further, the device for supporting the anti-glare plate 4 further includes: a buffer assembly configured to apply resistance to the rotating shaft 31 when the rotating shaft 31 is rotated. Specifically, the buffer assembly includes: a first connecting unit 71 fixed on the rotating shaft 31 and a second connecting unit 72 fixed on the supporting member 1. In one embodiment, the second connecting unit 72 is fixed to the connecting seat 5 on the supporting member 1. Wherein, the first connecting unit 71 is connected to the second connecting unit 72 through an elastic component 73. In this embodiment, the elastic component 73 may be various, such as a compression spring and a torsional spring, and will not be defined here. When the rotating shaft 31 is rotated, the first connecting unit 71 can be rotated with the rotating shaft 31, and the second connecting unit 72 on the connecting seat 5 is in an immovable state. Along with the rotation of the first connecting unit 71, the elastic component 73 connected between the first connecting unit 71 and the second connecting unit 72 may be elastically deformed, such as stretching or compressing. After the elastic component 73 is deformed, an elastic force can be generated to prohibit the rotation of the rotating shaft 31. The larger the rotation amplitude is, the larger the elastic resistance is. In an actual application process, when the barometric fluctuation is impacted to the anti-glare plate 4, under the action of a barometric pressure, the anti-glare plate 4 can drive the rotating shaft 31 to rotate. At this moment, the elastic component 73 can generate the elastic resistance to inhibit the rotation of the rotating shaft 31, and thus the rotation amplitude of the rotating shaft 31 may be gradually reduced till the rotating shaft is stopped at a preset balance position. Through providing the elastic component 73, the buffer action may be taken when the anti-glare plate 4 is rotated. In this way, on one hand, the rotation amplitude of the anti-glare plate 4 may be reduced to avoid hitting against the supporting member 1 due to the excessive large rotation amplitude. On the other hand, the buffer action may be taken to the rotation of the anti-glare plate 4, so that the anti-glare plate 4 is quickly returned to the preset balance position, thereby improving the service life of the anti-glare plate.

There may be various structural styles of the first connecting unit 71. Optionally, the first connecting unit 71 is protruded from an end portion of the rotating shaft 31. The first connecting unit 71 is of a strip-shaped structure. The first connecting unit 71 is extended along a radial direction of the rotating shaft 31. In this embodiment, the first connecting unit 71 with the strip-shaped structure may be arranged at the end portion of the rotating shaft 31 and its space occupation is relatively small, so the structure of the rotating shaft 31 is simplified. Through the first connecting unit 71 with the strip-shaped structure, the connection with the elastic component 73 may be more convenient. In addition, a connecting hole may be formed on the first connecting unit 71. The first connecting unit 71 may be connected with the elastic component 73 through the connecting hole. Besides, the first connecting unit may further be connected with the elastic component 73 using other connection manners such as integral molding, bolted connection and bonding, which will not be specifically defined here.

Optionally, the supporting member 1 includes: a first supporting beam 111, a second supporting beam 112, and supporting frames 12 configured to support the first supporting beam 111 and the second supporting beam 112. Wherein, the first connecting hole 21 and the second connecting hole 22 are respectively formed on the first supporting beam 111 and the second supporting beam 112. In this embodiment, the first supporting beam 111 and the second supporting beam 112 are taken as a main body supporting structure of the anti-glare plate 4, so the structural space of the supporting member 1 may be saved and the structure of the supporting member 1 is simplified. In addition, as the first supporting beam 111 and the second supporting beam 112 are respectively supported at the two ends of the rotating shaft 31, the first supporting beam 111 and the second supporting beam 112 may be stressed more uniformly, and the service life of each of the first supporting beam 111 and the second supporting beam 112 is improved. During actual use, the first supporting beam 111 and the second supporting beam 112 may be extended along the length direction of the expressway, the first supporting beam 111 and the second supporting beam 112 may be arranged at a preset height to the ground, and the anti-glare plate 4 may be suspended at lower sides of the first supporting beam 111 and the second supporting beam 112, so that the anti-glare plate 4 is in a suspending state. Additionally, the supporting frames 12 are mainly configured to support the above supporting beam structure. The supporting frames 12 may be of a frame type structure and may be made of a metal material to guarantee the supporting strength. The supporting member 1 at least includes two supporting frames 12. The two supporting frames 12 may be arranged at two ends of the supporting beams. If there are more than two supporting frames 12, other supporting frames 12 may be supported at middle portions of the supporting beams to improve the supporting effect to the supporting beams. The connection manner between the supporting frames 12 and the first supporting beam 111 and the second supporting beam 112 may be various, such as welding and bolted connection, and will not be specifically defined here.

Optionally, a connecting seat is arranged on the first supporting beam 111 and/or the second supporting beam 112. Wherein, the connecting seat includes a first seat body 61 and a second seat body 62 detachably connected. Wherein, a first groove 63 is formed on the first seat body 61, a second groove 64 is formed on the second seat body 62, and the first groove 63 and the second groove 64 are adapted to cooperatively define the first connecting hole 21 or the second connecting hole 22. In this embodiment, a connecting seat 5 is respectively arranged on the first supporting beam 111 and the second supporting beam 112. Each of the connecting seats 5 includes a first seat body 61 and a second seat body 62 detachably connected. The first seat body 61 may be fixed on the supporting member 1, and the second seat body 62 is detachably fixed on the first seat body 61. The fixing manner between the first seat body 61 and the supporting member 1 may be various, such as welding, bolted connection and integral molding, and will not be specifically defined here. The second seat body 62 and the first seat body 61 are matched in a structural form, so that the first seat body 61 and the second seat body 62 may be detachably connected. The detachable connection manner may be various, such as bolted connection and buckled connection, and will not be specifically defined here. When the first seat body 61 and the second seat body 62 are connected one another, the first groove 63 on the first seat body 61 and the second groove 64 on the second seat body 62 may be formed into the first connecting hole 21 or the second connecting hole 22. Wherein, the connecting holes formed by the first groove 63 and the second groove 64 may be of a through hole structure, may also be of a blind hole structure, and will not be specifically defined here. In addition, the groove shapes of the first groove 63 and the second groove 64 may also be various, such as a semi-arc groove, a rectangular groove and a triangular groove, and will not be specifically defined here. Preferably, the first groove 63 and the second groove 64 are arc grooves. The first groove 63 and the second groove 64 can be formed into a circular hole, wherein a radian proportion of the first groove 63 to the second groove 64 may also be various. For example, the first groove 63 and the second groove 64 both are semicircular arc grooves. Also for example, the first groove 63 may be a one-third arc groove, the second groove 64 is a two-third arc groove and a radian proportion of the first groove 63 to the second groove 64 may be designed according to a site condition, and will not be defined here. Through the connecting seat with the detachable structure provided by this embodiment, the disassembly and assembly between the rotating shaft 31 and the connecting seat 5 may be more convenient and quicker. Moreover, the structure is simple and the production cost is relatively low.

Further, multiple connecting structures 113 (see FIG. 2) are arranged on the first supporting beam 111 or the second supporting beam 112, wherein the connecting structures 113 are adapted to enable that the connecting seat is detachably arranged on the first supporting beam 111 or the second supporting beam 112. In this embodiment, there may be various connecting structures 113. For example, each of the connecting structures 113 may include a connecting seat hole formed on the first supporting beam 111 or the second supporting beam 112 and a connection bolt arranged on the first seat body 61, and the connection bolt may be detachably connected with the connecting seat hole. Also for example, each of the connecting structures 113 may be a connection binding band, a middle portion of the connection binding band is fixed on the first seat body and two ends of the connection binding band can be bound one another around the first supporting beam 111 or the second supporting beam 112. In this way, the connecting seat 5 may be connected through the connecting seat holes at different positions on the supporting beam 1 to implement the position adjustment of the connecting seat 5, and thus the spacing adjustment between adjacent anti-glare plates 4 is implemented and the use is more flexible.

In another aspect, an embodiment of the disclosure further provides an anti-glare device, which includes:
an anti-glare plate 4 and a device for supporting the anti-glare plate4; and the anti-glare plate 4 is mounted on the device.

This embodiment of the disclosure provides the anti-glare device, which is used for improving the service life of the anti-glare plate. However, in the prior art, the anti-glare plate is typically arranged on a separation zone of an expressway in a fixed manner. Due to a very fast vehicle speed on the expressway, when a vehicle passes through the anti-glare plate at a high speed, relatively large barometric fluctuation will be generated around the vehicle and the barometric fluctuation will drive the anti-glare plate on the separation zone to vibrate violently, so that the service life of the anti-glare plate is seriously affected. Compared with the prior art, the anti-glare device provided by the disclosure includes the anti-glare plate and the device for supporting an anti-glare plate, the anti-glare plate being mounted on the device for supporting an anti-glare plate, wherein the device includes the supporting member and the connecting member, and the connecting member is adapted to be connected with the supporting member and the anti-glare plate, and is configured to enable that the anti-glare plate can be rotated relative to the supporting member. When the vehicle is driven to pass through the anti-glare plate, the barometric fluctuation generated by the vehicle may be acted on the anti-glare plate. Since the anti-glare plate is fixed on the connecting member, the anti-glare plate may be rotated around the supporting frames. After the barometric fluctuation disappears, the anti-glare plate may be rotated again back to a preset position under the action of gravity; and in this way, the acting force generated by the barometric fluctuation may be removed and the service life of the anti-glare plate is improved.

Further, the anti-glare plate 4 includes a first glass layer, a photoelectric conversion chip and a second glass layer arranged in a laminated manner, wherein the first glass layer and the second glass layer both are exposed outside, and the photoelectric conversion chip is configured to absorb optical energy through the first glass layer and the second glass layer. In this embodiment, the photoelectric conversion chip is configured to absorb solar energy and convert the solar energy into electric energy. Wherein, the electric energy output by the photoelectric conversion chip may be directly applied to surrounding electrical devices, such as a traffic monitoring recording system, a server electrical device and an emergency facility. Therefore, the energy is saved and the wiring cost of a power system is reduced. Besides, the first glass layer and the second glass layer are respectively arranged at two sides of the photoelectric conversion chip. Through the first glass layer and the second glass layer, not only may the photoelectric conversion chip be protected, but also the solar energy may be absorbed by the photoelectric conversion chip through the first glass layer and the second glass layer and the absorption of the photoelectric conversion chip to the solar energy is guaranteed. Wherein, the first glass layer, the second glass layer and the photoelectric conversion chip may be connected through an EVE film or a PVB film using a thermal adhering manner to guarantee the connection stability of the photoelectric conversion chip. Optionally, the first glass layer and the second glass layer both are made of ground glass. Because the reflection of the ground glass is diffuse reflection, the first glass layer and the second glass layer may be prevented from reflecting light rays to eyes of a driver and thus the anti-glare effect is improved. In order to further improve the strength of the first glass layer and the second glass layer, the first glass layer and the second glass layer both may be made of tempered glass.

Further, the photoelectric conversion chip is a thin-film solar cell chip. Wherein, the thin-film solar cell chip has the advantages of light weight, thin thickness, flexibility, good light weakening property and adjustable color, etc.

The above are merely specific embodiments of the disclosure. However, the scope of protection of the disclosure is not limited to this. Any change or replacement readily conceived by a person skilled in the art within a technical scope of the disclosure should fall into the scope of protection of the disclosure. Accordingly, the scope of protection of the disclosure should be subject to that of claims.

## Claims

1. A device for supporting an anti-glare plate (4), comprising a supporting member (1) and a connecting member (3), wherein the connecting member (3) is connected with the supporting member (1) and the anti-glare plate (4), and is configured to enable the anti-glare plate (4) to rotate relative to the supporting member (1).

2. The device for supporting an anti-glare plate (4) according to claim 1, wherein,
the supporting member (1) has a first connecting hole (21) and a second connecting hole (22);
the connecting member (3) comprises a rotating shaft (31), one end of the rotating shaft (31) is rotatably connected to the first connecting hole (21), the other end of the rotating shaft (31) is rotatably connected to the second connecting hole (22), and the anti-glare plate (4) is fixed to the rotating shaft (31).

3. The device for supporting an anti-glare plate (4) according to claim 2, wherein the connecting member (3) further comprises a fixed part (32), the fixed part (32) is configured to fix the anti-glare plate (4) to the rotating shaft (31), the fixed part (32) is fixed to the rotating shaft (31), the fixed part (32) has a frame, the frame is configured to accommodate the anti-glare plate (4).

4. The device for supporting an anti-glare plate (4) according to claim 2, wherein the device further comprises a buffer assembly, the buffer assembly is configured to apply resistance to the rotating shaft (31) when the rotating shaft (31) is rotated.

5. The device for supporting an anti-glare plate (4) according to claim 4, wherein the buffer assembly comprises a first connecting unit (71), a second connecting unit (72) and an elastic component (73), the first connecting unit (71) is fixed on the rotating shaft (31), the second connecting unit (72) is fixed on the supporting member (1), and the first connecting unit (71) is connected to the second connecting unit (72) through the elastic component (73).

6. The device for supporting an anti-glare plate (4) according to claim 2, wherein the supporting member (1) comprises a first supporting beam (111), a second supporting beam (112) and a supporting frame (12), the supporting frame (12) is configured to support the first supporting beam (111) and the second supporting beam (112), the first connecting hole (21) is formed on the first supporting beam (111), and the second connecting hole (22) is formed on the second supporting beam (112).

7. The device for supporting an anti-glare plate (4) according to claim 6, wherein the supporting member (1) further comprises a connecting seat, the connecting seat is arranged on the first supporting beam (111), the connecting seat comprises a first seat body (61) and a second seat body (62), the first seat body (61) and the second seat body (62) are detachably connected, the first seat body (61) has a first groove (63), the second seat body (62) has a second groove (64), the first groove (63) and the second groove (64) are configured to cooperatively form the first connecting hole (21).

8. The device for supporting an anti-glare plate (4) according to claim 6, wherein the supporting member (1) further comprises a connecting seat, the connecting seat is arranged on the second supporting beam (112), the connecting seat comprises a first seat body (61) and a second seat body (62), the first seat body (61) and the second seat body (62) are detachably connected, the first seat body (61) has a first groove (63), the second seat body (62) has a second groove (64), the first groove (63) and the second groove (64) are configured to cooperatively form the second connecting hole (22).

9. The device for supporting an anti-glare plate (4) according to claim 6, wherein the supporting member (1) further comprises two connecting seats, one of the two connecting seats is arranged on the first supporting beam (111), and the other one of the two connecting seats is arranged on the second supporting beam (112), each one of the two connecting seats comprises a first seat body (61) and a second seat body (62), the first seat body (61) and the second seat body (62) are detachably connected, the first seat body (61) has a first groove (63), the second seat body (62) has a second groove (64), the first groove (63) and the second groove (64) are configured to cooperatively form the first connecting hole (21) or the second connecting hole (22).

10. The device for supporting an anti-glare plate (4) according to claim 9, wherein the supporting member (1) further comprises a plurality of connecting structures (113), the connecting structures (113) are arranged on the first supporting beam (111) and the second supporting beam (112), the connecting structures (113) are adapted to allow the connecting seats be detachably fixed on the first supporting beam (111) and the second supporting beam (112).

11. An anti-glare device, comprising an anti-glare plate (4) and a device for supporting the anti-glare plate (4) according to claim 1-10, wherein the anti-glare plate (4) is mounted on the device for supporting the anti-glare plate (4).

12. The anti-glare device according to claim 11, wherein the first supporting beam (111) and the second supporting beam (112) are arranged in an extension manner along a length direction of an expressway; and the anti-glare plate (4) is suspended at lower sides of the first supporting beam (111) and the second supporting beam (112).

13. The anti-glare device according to claim 12, wherein the anti-glare plate (4) comprises a first glass layer, a photoelectric conversion chip and a second glass layer, the first glass layer, the photoelectric conversion chip and the second glass layer are arranged in a laminated manner.

14. The anti-glare device according to claim 13, wherein both of the first glass layer and the second glass layer are made of ground glass.

15. The anti-glare device according to claim 13, wherein the photoelectric conversion chip is a thin-film solar cell chip.
